# EUROPEAN PATENT APPLICATION

(11) **EP 4 823 285 A1**
(43) Date of publication of application: **14.10.2026**
(21) Application number: 25850059.4
(22) Date of filing: 13.05.2025
(51) Int. Cl.: H10F 77/30

(54) **BACK-CONTACT SOLAR CELL, CELL MODULE, AND PHOTOVOLTAIC SYSTEM**

(30) Priority: 08.08.2024 CN 202411087630
(71) Applicant: Zhuhai Fushan Aiko Solar Technology Co., Ltd., Zhuhai, Guangdong 519000 (CN); Zhejiang Aiko Solar Technology Co., Ltd, Jinhua, Zhejiang 322000 (CN); Tianjin Aiko Solar Technology Co., Ltd, Tianjin 300400 (CN); Guangdong Aiko Solar Technology Co., Ltd, Foshan, Guangdong 528000 (CN)
(72) Inventor: ZHANG, Shengli, Jinhua, Zhejiang 322000 (CN); YANG, Haocheng, Jinhua, Zhejiang 322000 (CN); WANG, Yongqian, Jinhua, Zhejiang 322000 (CN); YANG, Xinqiang, Jinhua, Zhejiang 322000 (CN); CHEN, Gang, Jinhua, Zhejiang 322000 (CN)
(74) Representative: EP&C
(86) International application number: PCT/CN2025/094625
(87) International publication number: WO 2026/031690

(57) **Abstract**

Provided are a back-contact solar cell, a cell assembly and a photovoltaic system, which are applicable to the technical field of solar cells. The back-contact solar cell includes: a silicon substrate, where a back surface of the silicon substrate including P regions and N regions; a first passivation contact structure including a first passivation layer, a first P-type doped polysilicon layer, a first barrier layer and a second P-type doped polysilicon layer; and a second passivation contact structure including a second passivation layer, a first N-type doped polysilicon layer, a second barrier layer and a second N-type doped polysilicon layer. A doping concentration of a P-type dopant in the first P-type doped polysilicon layer is greater than a doping concentration of a P-type dopant in the second P-type doped polysilicon layer, and a doping concentration of N-type dopant in the first N-type doped polysilicon layer is a doping concentration less than a doping concentration of an N-type dopant in the second N-type doped polysilicon layer. The back-contact solar cell of the disclosure can reduce inward diffusion of impurities into the silicon substrate, and can improve a light transmittance of the P regions, thereby improving cell efficiency.

## Description

### Cross-Reference to Related Application

The disclosure refers to Chinese Patent Application No. 202411087630.7, filed on August 8, 2024 and entitled "Back-contact solar cell, cell assembly and photovoltaic system", which is incorporated in its entirety herein by reference.

### Technical Field

The disclosure relates to the technical field of solar cells, and in particular to a back-contact solar cell, a cell assembly and a photovoltaic system.

### Background Art

Positive/negative electrodes of a back-contact solar cell is designed on a back surface of the cell. Compared with a double-sided solar cell, a shield of metal gate lines is thoroughly avoided in a front surface of the back-contact solar cell, thereby eliminating optical losses caused by the shielding of the metal grid line, and greatly improving conversion efficiency of the cell.

In the related art, P region and N region are alternately disposed on a back surface of a silicon substrate of the back-contact solar cell, and the P regions and the N regions are provided with passivation contact structures correspondingly. Specifically, the passivation contact structure of the P regions is a combination of single P-type doped polysilicon layer and single passivation layer, and the passivation contact structure of the N regions is a combination of single N-type doped polysilicon layer and single passivation layer. However, impurities introduced during a process for preparing a back-contact solar cell are likely to diffuse into the silicon substrate since each of the passivation contact structures of the P regions and the N regions of the back-contact solar cell is the combination of the single doped polycrystalline silicon layer and the single passivation layer, resulting in a poor passivation effect of the solar cell, and affecting efficiency of the solar cell.

### Summary

The disclosure provides a back-contact solar cell, which aims to solve the problem that a passivation contact structure of a back-contact solar cell in the related art is a single doped polysilicon layer and a single passivation layer, resulting in a poor passivation effect of the back-contact solar cell and low cell efficiency.

The disclosure is implemented by providing a back-contact solar cell. The back-contact solar cell includes:
a silicon substrate, where a back surface of the silicon substrate includes P regions and N regions;
a first passivation contact structure disposed in the P regions, where the first passivation contact structure includes a first passivation layer, a first P-type doped polysilicon layer, a first barrier layer and a second P-type doped polysilicon layer sequentially stacked on the back surface of the silicon substrate; and
a second passivation contact structure disposed in the N regions, where the second passivation contact structure includes a second passivation layer, a first N-type doped polysilicon layer, a second barrier layer and a second N-type doped polysilicon layer sequentially stacked on the back surface of the silicon substrate;
where a doping concentration of a P-type dopant in the first P-type doped polysilicon layer is greater than a doping concentration of a P-type dopant in the second P-type doped polysilicon layer, and a doping concentration of an N-type dopant in the first N-type doped polysilicon layer is less than a doping concentration of an N-type dopant in the second N-type doped polysilicon layer.

In some embodiments, a ratio of the doping concentration of the P-type dopant in the first P-type doped polysilicon layer to the doping concentration of the P-type dopant in the second P-type doped polysilicon layer ranges from 1 to 2, and is unequal to 1.

In some embodiments, a ratio of the doping concentration of the P-type dopant in the first P-type doped polysilicon layer to the doping concentration of the P-type dopant in the second P-type doped polysilicon layer ranges from 1.01 to 1.50.

In some embodiments, the doping concentration of the P-type dopant in the first P-type doped polysilicon layer and the doping concentration of the P-type dopant in the second P-type doped polysilicon layer both range from 3×10¹⁹ atoms/cm³ to 15×10¹⁹ atoms/cm³.

In some embodiments, a ratio of the doping concentration of the N-type dopant in the first N-type doped polysilicon layer to the doping concentration of the N-type dopant in the second N-type doped polysilicon layer ranges from 0.5 to 1.

In some embodiments, the doping concentration of the N-type dopant in the first N-type doped polysilicon layer and the doping concentration of the N-type dopant in the second N-type doped polysilicon layer both range from 0.5×10²⁰ atoms/cm³ to 1.2×10²¹ atoms/cm³.

In some embodiments, the back-contact solar cell further including:
first electrodes each disposed in one of the P regions, contacting the second P-type doped polysilicon layer; and
second electrodes each disposed in one of the N regions, contacting the second N-type doped polysilicon layer.

In some embodiments, a thickness of the first P-type doped polysilicon layer is less than a thickness of the second P-type doped polysilicon layer.

In some embodiments, a thickness of the first N-type doped polysilicon layer is less than a thickness of the second N-type doped polysilicon layer.

In some embodiments, a ratio of the thickness of the second P-type doped polysilicon layer to the thickness of the first P-type doped polysilicon layer ranges from 1 to 30.

In some embodiments, a ratio of the thickness of the second P-type doped polysilicon layer to the thickness of the first P-type doped polysilicon layer ranges from 1.5 to 15.

In some embodiments, a sum of a thickness of the first P-type doped polysilicon layer and a thickness of the second P-type doped polysilicon layer ranges from 80 nanometers to 210 nanometers.

In some embodiments, a sum of a thickness of the first N-type doped polysilicon layer and a thickness of the second N-type doped polysilicon layer ranges from 60 nanometers to 200 nanometers.

In some embodiments, a sum of a thickness of the first P-type doped polysilicon layer and a thickness of the second P-type doped polysilicon layer is greater than a sum of a thickness of the first N-type doped polysilicon layer and a thickness of the second N-type doped polysilicon layer.

In some embodiments, a sum of a thicknesses of the first passivation layer and a thickness of the first barrier layer ranges from 1.5 nanometers to 2.8 nanometers.

In some embodiments, a sum of a thickness of the first passivation layer and a thickness of the first barrier layer is greater than a sum of a thickness of the second passivation layer and a thickness of the second barrier layer.

In some embodiments, a thickness of the first barrier layer is greater than 0.8 nanometer.

In some embodiments, a ratio of the thickness of the second N-type doped polysilicon layer to the thickness of the first N-type doped polysilicon layer ranges from 1 to 40.

In some embodiments, a ratio of the thickness of the second N-type doped polysilicon layer to the thickness of the first N-type doped polysilicon layer ranges from 2 to 20.

In some embodiments, the first electrode enters the second P-type doped polysilicon layer and does not enter the first barrier layer, and the second electrode enters the second N-type doped polysilicon layer and does not enter the second barrier layer.

In some embodiments, a depth that the first electrode enters the second P-type doped polysilicon layer is greater than a depth that the second electrode enters the second N-type doped polysilicon layer.

In some embodiments, a total thickness of the first passivation layer, the first P-type doped polysilicon layer, the first barrier layer and the second P-type doped polysilicon layer is greater than a total thickness of the second passivation layer, the first N-type doped polysilicon layer, the second barrier layer and the second N-type doped polysilicon layer.

In some embodiments, a thickness of the second P-type doped polysilicon layer is greater than a thickness of the second N-type doped polysilicon layer.

In some embodiments, a thickness of the second N-type doped polysilicon layer is greater than a thickness of the first P-type doped polysilicon layer.

In some embodiments, a thickness of the first P-type doped polysilicon layer is greater than a thickness of the first N-type doped polysilicon layer.

In some embodiments, a thickness of the first passivation layer is greater than a thickness of the first barrier layer; and a thickness of the second passivation layer is greater than a thickness of the second barrier layer.

In some embodiments, the first passivation layer includes one or a combination of silicon oxide, silicon oxynitride and silicon nitride containing boron or gallium; and the second passivation layer includes one or a combination of silicon oxide, silicon oxynitride and silicon nitride containing phosphorus.

In some embodiments, the first barrier layer includes one or a combination of silicon oxide, silicon oxynitride, silicon nitride and silicon carbide, each of which contains boron or gallium; and the second barrier layer includes one or a combination of silicon oxide, silicon oxynitride, silicon nitride and silicon carbide, each of which contains phosphorus.

In some embodiments, the first passivation contact structure further includes:
a third barrier layer disposed on a surface of the second P-type doped polysilicon layer away from the silicon substrate.

In some embodiments, a thickness of the third barrier layer is less than a thickness of the first passivation layer.

In some embodiments, the first passivation contact structure further includes:
a third P-type doped polysilicon layer disposed on a surface of the third barrier layer away from the silicon substrate.

In some embodiments, a doping concentration of a P-type dopant in the second P-type doped polysilicon layer is greater than a doping concentration of a P-type dopant in the third P-type doped polysilicon layer.

In some embodiments, the second passivation contact structure further includes:
a fourth barrier layer disposed on a surface of the second N-type doped polysilicon layer away from the silicon substrate.

In some embodiments, a thickness of the fourth barrier layer is less than a thickness of the second passivation layer.

In some embodiments, the second passivation contact structure further includes:
a third N-type doped polysilicon layer disposed on a surface of the fourth barrier layer away from the silicon substrate.

In some embodiments, a doping concentration of an N-type dopant in the third N-type doped polysilicon layer is greater than a doping concentration of a N-type dopant in the second N-type doped polysilicon layer.

The disclosure further provides a cell assembly. The cell assembly includes the above back-contact solar cell.

The disclosure further provides a photovoltaic system. The photovoltaic system includes the above cell assembly.

The first passivation contact structure of the P regions of the back-contact solar cell according to the disclosure includes the first passivation layer, the first P-type doped polysilicon layer, the first barrier layer and the second P-type doped polysilicon layer sequentially stacked on the surface of the silicon substrate, and the second passivation contact structure of the N regions includes the second passivation layer, the first N-type doped polysilicon layer, the second barrier layer and the second N-type doped polysilicon layer sequentially stacked on the surface of the silicon substrate. The first passivation contact structure stops impurities from diffusing inwards into the silicon substrate together by the first passivation layer and the first barrier layer, and the second passivation contact structure stops impurities from diffusing inwards into the silicon substrate together by the second passivation layer and the second barrier layer such that inward diffusion of the impurities into the silicon substrate can be obviously reduced, and excessive impurities can be prevented from diffusing into the silicon substrate, and a passivation effect of the back-contact solar cell can be improved, thereby improving cell efficiency.

Moreover, the doping concentration of the P-type dopant in the first P-type doped polysilicon layer of the back-contact solar cell of the disclosure is greater than the doping concentration of the P-type dopant in the second P-type doped polysilicon layer, and the doping concentration of the N-type dopant in the first N-type doped polysilicon layer is less than the doping concentration of the N-type dopant in the second N-type doped polysilicon layer. By reducing the doping concentration of the P-type dopant in the second P-type doped polysilicon layer of the P regions, a light transmittance of the second P-type doped polysilicon layer can be increased, thereby increasing the light transmission quantity of the P regions, improving a utilization rate of the back-contact solar cell to sunlight, and further improving the cell efficiency.

### Brief Description of the Drawings

Fig. 1 is a schematic cutaway view of a back-contact solar cell according to Example 1 of the disclosure; and
Fig. 2 is a schematic cutaway view of a back-contact solar cell according to Example 2 of the disclosure.

Symbol description of main elements:
1, silicon substrate; 2, first passivation contact structure; 3, second passivation contact structure; 4, first electrode; 5, second electrode; 11, P region; 12, N region; 13, isolation region; 101, back surface; 102, front surface; 21, first passivation layer; 22, first P-type doped polysilicon layer; 23, first barrier layer; 24, second P-type doped polysilicon layer; 25, third barrier layer; 26, third P-type doped polysilicon layer; 31, second passivation layer; 32, first N-type doped polysilicon layer; 33, second barrier layer; 34, second N-type doped polysilicon layer; 35, fourth barrier layer; and 36, third N-type doped polysilicon layer.

### Detailed Description of the Embodiments

In order to make the objectives, technical solutions and advantages of the disclosure clearer, the disclosure will be further described in detail below in combination with the accompanying drawings and the embodiments. It should be understood that the particular embodiments described herein are merely illustrative of the disclosure and are not intended to limit the disclosure.

A first passivation contact structure of P regions of a back-contact solar cell according to the disclosure includes a first passivation layer, a first P-type doped polysilicon layer, a first barrier layer and a second P-type doped polysilicon layer sequentially stacked on a surface of a silicon substrate, and a second passivation contact structure of N regions includes a second passivation layer, a first N-type doped polysilicon layer, a second barrier layer and a second N-type doped polysilicon layer sequentially stacked on the surface of the silicon substrate. The first passivation contact structure stops impurities from diffusing inwards into the silicon substrate together by the first passivation layer and the first barrier layer, and the second passivation contact structure stops impurities from diffusing inwards into the silicon substrate together by the second passivation layer and the second barrier layer, such that inward diffusion of the impurities into the silicon substrate can be reduced, and excessive impurities can be prevented from diffusing into the silicon substrate, and a passivation effect of the back-contact solar cell can be improved, thereby improving cell efficiency.

Moreover, a doping concentration of a P-type dopant in the first P-type doped polysilicon layer of the back-contact solar cell of the disclosure is greater than a doping concentration of a P-type dopant in the second P-type doped polysilicon layer, and a doping concentration of an N-type dopant in the first N-type doped polysilicon layer is less than a doping concentration of the N-type dopant in the second N-type doped polysilicon layer. By reducing the doping concentration of the P-type dopant in the second P-type doped polysilicon layer of the P regions, a light transmittance of the second P-type doped polysilicon layer can be increased to increase a light transmission quantity of the P regions, thereby improving a utilization rate of the back-contact solar cell to sunlight, and further improving the cell efficiency.

### Embodiment 1

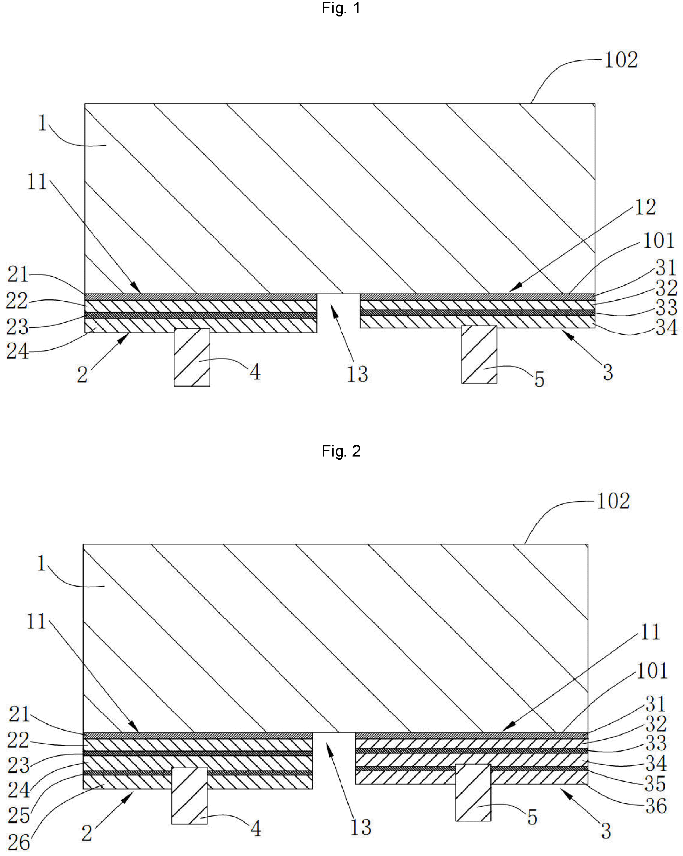

With reference to Fig. 1, a back-contact solar cell is provided in an embodiment of the disclosure. The back-contact solar cell includes:
a silicon substrate 1, where a back surface 101 of the silicon substrate 1 includes P regions 11 and N regions 12;
a first passivation contact structure 2 disposed in the P regions 11, where the first passivation contact structure 2 includes a first passivation layer 21, a first P-type doped polysilicon layer 22, a first barrier layer 23 and a second P-type doped polysilicon layer 24 sequentially stacked on the back surface of the silicon substrate 1; and
a second passivation contact structure 3 disposed in the N regions 12, where the second passivation contact structure 3 includes a second passivation layer 31, a first N-type doped polysilicon layer 32, a second barrier layer 33 and a second N-type doped polysilicon layer 34 sequentially stacked on the back surface of the silicon substrate 1; and
a doping concentration of a P-type dopant in the first P-type doped polysilicon layer 22 is greater than a doping concentration of a P-type dopant in the second P-type doped polysilicon layer 24, and a doping concentration of an N-type dopant in the first N-type doped polysilicon layer 32 is less than a doping concentration of an N-type dopant in the second N-type doped polysilicon layer 34.

In the embodiment of the disclosure, the doping concentration of the P-type dopant is a mean or a peak of the doping concentration of the P-type dopant, and the doping concentration of the N-type dopant is a mean or a peak of the doping concentration of the N-type dopant, in which the peak of the doping concentration is a maximum doping concentration. In the embodiment of the disclosure, the mean or the peak of the doping concentration is used for comparison when the doping concentration of the P-type dopant or the doping concentration of the N-type dopant is compared. It can be understood that in some embodiments, a mean of a doping concentration of a P-type dopant in any region of the first P-type doped polysilicon layer 22 is greater than a mean of a doping concentration of a P-type dopant in any region of the second P-type doped polysilicon layer 24; and a mean of a doping concentration of an N-type dopant in any region of a first N-type doped polysilicon layer 32 is less than a mean of a doping concentration of an N-type dopant in any region of a second N-type doped polysilicon layer 34.

In some other embodiments, a peak of a doping concentration of a P-type dopant in any region of the first P-type doped polysilicon layer 22 is greater than a peak of a doping concentration of the P-type dopant in any region of a second P-type doped polysilicon layer 24; and a peak of a doping concentration of an N-type dopant in any region of the first N-type doped polysilicon layer 32 is less than a peak of a doping concentration of an N-type dopant in any region of the second N-type doped polysilicon layer 34.

In the embodiment of the disclosure, the silicon substrate 1 is a P-type silicon substrate 1. In some other embodiments, the silicon substrate 1 is an N-type silicon substrate 1. A back surface 101 of the silicon substrate 1 is a rear side of the back-contact solar cell, and a front surface 102 of the silicon substrate 1 is a light-facing side of the back-contact solar cell. A plurality of P regions 11 and a plurality of N regions 12 are disposed on the back surface 101 of the silicon substrate 1, the P region 11 and the N region 12 are disposed sequentially and alternately, and an isolation region 13 is disposed between each adjacent P region 11 and N region 12. In some embodiments, an isolation region 13 is a groove. In some other embodiments, an isolation region 13 is a gap.

The first passivation contact structure 2 of the P regions 11 of the back-contact solar cell according to the disclosure includes the first passivation layer 21, the first P-type doped polysilicon layer 22, the first barrier layer 23 and the second P-type doped polysilicon layer 24 sequentially stacked on the surface of the silicon substrate 1, and the second passivation contact structure 3 of the N region 12 includes the second passivation layer 31, the first N-type doped polysilicon layer 32, the second barrier layer 33 and the second N-type doped polysilicon layer 34 sequentially stacked on the surface of the silicon substrate 1. The first passivation contact structure 2 stops impurities from diffusing inwards into the silicon substrate 1 together by the first passivation layer 21 and the first barrier layer 23, and the second passivation contact structure 3 stops impurities from diffusing inwards into the silicon substrate 1 together by the second passivation layer 31 and the second barrier layer 33, such that inward diffusion of the impurities into the silicon substrate 1 can be reduced, and excessive impurities can be prevented from diffusing into the silicon substrate 1, and a passivation effect of the back-contact solar cell can be obviously improved, thereby improving cell efficiency.

Moreover, the doping concentration of the P-type dopant in the first P-type doped polysilicon layer 22 of the back-contact solar cell of the disclosure is set to be greater than the doping concentration of the P-type dopant in the second P-type doped polysilicon layer 24, and the doping concentration of the N-type dopant in the first N-type doped polysilicon layer 32 is set to be less than the doping concentration of the N-type dopant in the second N-type doped polysilicon layer 34. On the premise that the doping concentration of the P-type dopant in the first P-type doped polysilicon layer 22 is unchanged, by reducing the doping concentration of the P-type dopant in the second P-type doped polysilicon layer 24 of the P regions 11, a light transmittance of the second P-type doped polysilicon layer 24 can be increased to increase a light transmission quantity, thereby improving a utilization rate of the back-contact solar cell to sunlight, and further improving the cell efficiency.

In the embodiment of the disclosure, the P-type dopant may be boron or gallium, and the N-type dopant may be phosphorus or arsenic. In some other embodiments, a P-type dopant is boron, and an N-type dopant is phosphorus. In practical applications, the doping concentration of the P-type dopant is a doping concentration of an activated P-type dopant, and the doping concentration of the N-type dopant is a doping concentration of an activated N-type dopant. The doping concentration of the activated P-type dopant and the doping concentration of the activated N-type dopant are measured by a spreading resistance profile (SRP) or an electrochemical capacitance-voltage (ECV) method. In some other embodiments, a doping concentration of a P-type dopant is the sum of a doping concentration of activated P-type dopant and a doping concentration of a non-activated P-type dopant, and a doping concentration of an N-type dopant is the sum of a doping concentration of an activated N-type dopant and a doping concentration of a non-activated N-type dopant. The doping concentration of the P-type dopant and the doping concentration of the N-type dopant are measured by means of secondary ion mass spectrometry (SIMS).

In practical applications, after the second P-type doped polysilicon layer 24 is prepared, the second P-type doped polysilicon layer 24 would be oxidized at a high temperature to form an oxide layer. In some embodiments, an oxide layer is borosilicate glass. Part of the P-type dopant inside the second P-type doped polysilicon layer 24 is extracted by the oxide layer, and then the oxide layer is removed, such that the doping concentration of the P-type dopant in the first P-type doped polysilicon layer 22 can be greater than a doping concentration of the P-type dopant in the second P-type doped polysilicon layer 24.

As some optional embodiments of the disclosure, a first passivation layer 21, a first P-type doped polysilicon layer 22, a first barrier layer 23 and a second P-type doped polysilicon layer 24 are doped with boron, and a doping concentration of boron atoms of the first P-type doped polysilicon layer 22 is greater than a doping concentration of boron atoms of the second P-type doped polysilicon layer 24. A second passivation layer 31, a first N-type doped polysilicon layer 32, a second barrier layer 33 and a second N-type doped polysilicon layer 34 are doped with phosphorus, and a doping concentration of phosphorus atoms of the first N-type doped polysilicon layer 32 is less than a doping concentration of phosphorus atoms of the second N-type doped polysilicon layer 34.

In some embodiments of the disclosure, a ratio of a doping concentration of a P-type dopant in a first P-type doped polysilicon layer 22 to a doping concentration of a P-type dopant in a second P-type doped polysilicon layer 24 ranges from 1 to 2, and is unequal to 1.

In the embodiment, the ratio of the doping concentration of the P-type dopant in the first P-type doped polysilicon layer 22 to the doping concentration of the P-type dopant in the second P-type doped polysilicon layer 24 is greater than 1 and less than 2. Thus, an excellent light transmission effect of the P region can be ensured, and it is convenient to prepare the first P-type doped polysilicon layer 22 and the second P-type doped polysilicon layer 24.

The ratio of the doping concentration of the P-type dopant in the first P-type doped polysilicon layer 22 to the doping concentration of the P-type dopant in the second P-type doped polysilicon layer 24 may be set according to actual requirements. For example, the ratio of the doping concentration of the P-type dopant in the first P-type doped polysilicon layer 22 to the doping concentration of the P-type dopant in the second P-type doped polysilicon layer 24 may be 1.01, 1.20, 1.25, 1.28, 1.30, 1.32, 1.37, 1.40, 1.45, 1.50, 1.52, 1.56, 1.60, 1.65, 1.70, 1.78, 1.80, 1.84, 1.90, 1.95, or 2.0.

In some embodiments of the disclosure, a ratio of a doping concentration of a P-type dopant in a first P-type doped polysilicon layer 22 to a doping concentration of a P-type dopant in a second P-type doped polysilicon layer 24 ranges from 1.01 to 1.50. Thus, a light transmission effect of the P region 11 can be further improved, and it is convenient to prepare the first P-type doped polysilicon layer 22 and the second P-type doped polysilicon layer 24.

In some embodiments of the disclosure, a doping concentration of a P-type dopant in a first P-type doped polysilicon layer 22 and a doping concentration of a P-type dopant in a second P-type doped polysilicon layer 24 both range from 3×10¹⁹ atoms/cm³ to 15×10¹⁹ atoms/cm³.

In the embodiment, the doping concentration of the P-type dopant in the first P-type doped polysilicon layer 22 and the doping concentration of the P-type dopant in the second P-type doped polysilicon layer 24 both range from 3×10¹⁹ atoms/cm³ to 15×10¹⁹ atoms/cm³, and it is only necessary to satisfy that the doping concentration of the P-type dopant in the first P-type doped polysilicon layer 22 is greater than the doping concentration of the P-type dopant in the second P-type doped polysilicon layer 24. For example, the P-type dopant is boron, and the doping concentration of the P-type dopant in the first P-type doped polysilicon layer 22 and the doping concentration of the boron atoms of the second P-type doped polysilicon layer 24 both range from 3×10¹⁹ atoms/cm³ to 15×10¹⁹ atoms/cm³, and the doping concentration of the boron atoms in the first P-type doped polysilicon layer 22 is greater than the doping concentration of the boron atoms in the second P-type doped polysilicon layer 24.

In some embodiments of the disclosure, a ratio of a doping concentration of an N-type dopant in a first N-type doped polysilicon layer 32 to a doping concentration of an N-type dopant in a second N-type doped polysilicon layer 34 ranges from 0.5 to 1.

The ratio of the doping concentration of the N-type dopant in the first N-type doped polysilicon layer 32 to the doping concentration of the N-type dopant in the second N-type doped polysilicon layer 34 may be set according to actual requirements, and the doping concentration of the N-type dopant in the first N-type doped polysilicon layer 32 is less than the doping concentration of the N-type dopant in the second N-type doped polysilicon layer 34. In some other embodiments, a doping concentration of an N-type dopant in a first N-type doped polysilicon layer 32 may equal to a doping concentration of an N-type dopant in a second N-type doped polysilicon layer 34. For example, a ratio of the doping concentration of the N-type dopant in the first N-type doped polysilicon layer 32 to the doping concentration of the N-type dopant in the second N-type doped polysilicon layer 34 may be 0.50, 0.52, 0.61, 0.65, 0.68, 0.70, 0.78, 0.80, 0.86, 0.90, 0.94, or 1.

In some other embodiments of the disclosure, a doping concentration of an N-type dopant in a first N-type doped polysilicon layer 32 and a doping concentration of an N-type dopant in a second N-type doped polysilicon layer 34 both range from 0.5×10²⁰ atoms/cm³ to 1.2×10²¹ atoms/cm³.

In the embodiment, the doping concentration of the N-type dopant in the first N-type doped polysilicon layer 32 and the doping concentration of the N-type dopant in the second N-type doped polysilicon layer 34 both range from 0.5×10²⁰ atoms/cm³ to 1.2×10²¹ atoms/cm³, and the doping concentration of the N-type dopant in the first N-type doped polysilicon layer 32 is less than or equal to the doping concentration of the N-type dopant in the second N-type doped polysilicon layer 34. For example, the N-type dopant is phosphorus, and the doping concentration of phosphorus atoms in the first N-type doped polysilicon layer 32 and the doping concentration of phosphorus atoms in the second N-type doped polysilicon layer 34 both range from 0.5×10²⁰ atoms/cm³ to 1.2×10²¹ atoms/cm³.

In some embodiments of the disclosure, a back-contact solar cell further includes:
first electrodes 4 each disposed in one of the P regions 11, contacting the second P-type doped polysilicon layer 24; and
second electrodes 5 each disposed in one of the N regions 12, contacting the second N-type doped polysilicon layer 34.

In the embodiment, the first electrodes 4 contact with the second P-type doped polysilicon layer 24 to achieve ohmic contact, and the second electrodes 5 contact with the second N-type doped polysilicon layer 34 to achieve ohmic contact.

In the embodiment, by providing the first P-type doped polysilicon layer 22 and the second P-type doped polysilicon layer 24, the first passivation contact structure 2 of the P regions 11 achieves an original effect of passivation by the first P-type doped polysilicon layer 22, and achieves an effect of lateral current transmission and forms ohmic contact with the first electrode 4 by the second P-type doped polysilicon layer 24. By providing the first N-type doped polysilicon layer 32 and the second N-type doped polysilicon layer 34, the second passivation contact structure 3 of the N regions 12 achieves the original effect of passivation by the first N-type doped polysilicon layer 32, and achieves the effect of lateral current transmission and forms ohmic contact with the second electrode 5 by the second N-type doped polysilicon layer 34. In some other embodiments, first electrodes 4 contact with the first P-type doped polysilicon layer 22, and second electrodes 5 contact with the first N-type doped polysilicon layer 32.

In a embodiment of the disclosure, the first electrode 4 enters the second P-type doped polysilicon layer 24 and does not enter the first barrier layer 23, and the second electrode 5 enters the second N-type doped polysilicon layer 34 and does not enter the second barrier layer 33.

In the embodiment, a depth by which the first electrode 4 enters the second P-doped polysilicon layer 24 is less than the thickness of the second P-type doped polysilicon layer 24, and the first electrode 4 only enters the second P-type doped polysilicon layer 24 and does not enter the first barrier layer 23, and the first electrode 4 only makes contact with the second P-type doped polysilicon layer 24. Thus, the first barrier layer 23 is prevented from being damaged, such that the first barrier layer 23 maintains an excellent effect of stopping impurities from diffusing inwards into the silicon substrate 1. Moreover, slurry of the first electrode 4 is prevented from entering the first barrier layer 23 and the first P-type doped polysilicon layer 22 to burn through the first passivation layer 21, and the first electrode 4 is prevented from making direct contact with the silicon substrate 1, thereby improving the passivation effect of the cell.

In the embodiment, the depth by which the second electrode 5 enters the second N-type doped polysilicon layer 34 is less than the thickness of the second N-type doped polysilicon layer 34, and the second electrode 5 only enters the second N-type doped polysilicon layer 34 and does not enter the second barrier layer 33, and the second electrode 5 only makes contact with the second N-type doped polysilicon layer 34. Thus, the second barrier layer 33 is prevented from being damaged, such that the second barrier layer 33 maintains an excellent effect of stopping impurities from diffusing inwards into the silicon substrate 1. Moreover, slurry of the second electrode 5 is prevented from entering the second barrier layer 33 and the first N-type doped polysilicon layer 32 to burn through the second passivation layer 31, and the second electrode 5 is prevented from making direct contact with the silicon substrate 1, thereby improving the passivation effect of the cell.

In some embodiments of the disclosure, a depth by which a first electrode 4 enters a second P-type doped polysilicon layer 24 is greater than a depth by which a second electrode 5 enters a second N-type doped polysilicon layer 34.

In the embodiment, the depth by which the first electrode 4 enters the second P-type doped polysilicon layer 24 is greater than the depth by which the second electrode 5 enters the second N-type doped polysilicon layer 34. Thus, a contact area between the first electrode 4 and the second P-type doped polysilicon layer 24 can be increased, and a contact effect between the first electrode 4 and the second P-type doped polysilicon layer 24 can be enhanced, such that the second electrode 5 and the second P-type doped polysilicon layer 24 form excellent ohmic contact, and a conductive effect of the P region 11 can be improved, thereby improving conversion efficiency of the cell.

In some embodiments of the disclosure, a thickness of a first P-type doped polysilicon layer 22 is less than a thickness of a second P-type doped polysilicon layer 24.

In the embodiment, since a passivation contact structure of a P region 11 of an existing conventional back-contact solar cell only includes a single P-type doped polysilicon layer, the single doped polysilicon layer has effects of passivation, lateral current transmission and ohmic contact with metal electrodes. In the embodiment of the disclosure, by providing the first P-type doped polysilicon layer 22 and the second P-type doped polysilicon layer 24, the first passivation contact structure 2 of the P regions 11 achieves the original effect of passivation by the first P-type doped polysilicon layer 22, and achieves the effects of lateral current transmission and ohmic contact with metal electrodes by the second P-type doped polysilicon layer 24. Thus, the thickness of the first P-type doped polysilicon layer 22 is reduced such that excellent passivation effect of the first P-type doped polysilicon layer 22 can be achieved. Since the thicker the second P-type doped polysilicon layer 24 is, the smaller a lateral transmission resistor is, by increasing the thickness of the second P-type doped polysilicon layer 24, the second P-type doped polysilicon layer 24 can achieve excellent effects of lateral current transmission and ohmic contact with the metal electrodes. Moreover, the doping concentration of the P-type dopant in the first P-type doped polysilicon layer 22 and the doping concentration of the P-type dopant in the second P-type doped polysilicon layer 24 can be adjusted to be adapted to the effects of ohmic contact and passivation of the P regions 11 of the back-contact solar cell.

In some embodiments of the disclosure, a thickness of the first N-type doped polysilicon layer 32 is less than a thickness of the second N-type doped polysilicon layer 34.

In the embodiment, since a passivation contact structure of N regions 12 of an existing conventional back-contact solar cell only includes a single N-type doped polysilicon layer, the single doped polysilicon layer has effects of passivation, lateral current transmission and ohmic contact with metal electrodes. In the embodiment of the disclosure, by providing the first N-type doped polysilicon layer 32 and the second N-type doped polysilicon layer 34, the first passivation contact structure 2 of the N regions 12 achieves the original effect of passivation by the first N-type doped polysilicon layer 32, and achieves the effects of lateral current transmission and ohmic contact with the metal electrodes by the second N-type doped polysilicon layer 34. Thus, the thickness of the first N-type doped polysilicon layer 32 can be reduced such that the first N-type doped polysilicon layer 32 can achieve an excellent passivation effect. Since the thicker the second N-type doped polysilicon layer 34 is, the smaller the lateral transmission resistor is, by increasing the thickness of the second N-type doped polysilicon layer 34, the second N-type doped polysilicon layer 34 can achieve the excellent effects of lateral current transmission and ohmic contact with the metal electrodes. Moreover, the doping concentration of the N-type dopant in the first N-type doped polysilicon layer 32 and the doping concentration of the N-type dopant in the second N-type doped polysilicon layer 34 can be adjusted to be adapted to the effects of ohmic contact and passivation of the N regions 12 of the back-contact solar cell.

In some embodiments of the disclosure, a ratio of a thickness of a second P-type doped polysilicon layer 24 to a thickness of a first P-type doped polysilicon layer 22 ranges from 1 to 30.

In the embodiment, the ratio of the thickness of the second P-type doped polysilicon layer 24 to the thickness of the first P-type doped polysilicon layer 22 may be set according to actual requirements. For example, the ratio of the thickness of the second P-type doped polysilicon layer 24 to the thickness of the first P-type doped polysilicon layer 22 may be 1, 2, 3, 5, 8, 10, 12, 15, 18, 20, 22, 25, 28, or 30.

In a embodiment of the disclosure, a ratio of a thickness of a second P-type doped polysilicon layer 24 to a thickness of a first P-type doped polysilicon layer 22 ranges from 1.5 to 15.

In the embodiment, the ratio of the thickness of the second P-type doped polysilicon layer 24 to the thickness of the first P-type doped polysilicon layer 22 ranges from 1.5 to 15. Thus, it is ensured that a difference between the thickness of the second P-type doped polysilicon layer 24 and the thickness of the first P-type doped polysilicon layer 22 is within a more reasonable range, such that excellent ohmic contact with the second P-type doped polysilicon layer 24 and the excellent passivation effect of the first P-type doped polysilicon layer 22 can be well adapted, and it is convenient to prepare the second P-type doped polysilicon layer 24 and the first P-type doped polysilicon layer 22.

In some embodiments of the disclosure, a sum of a thickness of a first P-type doped polysilicon layer 22 and a thickness of a second P-type doped polysilicon layer 24 is greater than a sum of a thickness of a first N-type doped polysilicon layer 32 and a thickness of a second N-type doped polysilicon layer 34.

In the embodiment, since the sum of the thickness of the first P-type doped polysilicon layer 22 and the thickness of the second P-type doped polysilicon layer 24 is greater than the sum of the thickness of the first N-type doped polysilicon layer 32 and the thickness of the second N-type doped polysilicon layer 34, the passivation effect of the P regions 11 can be improved, thereby improving the efficiency of the cell. Moreover, the electrode of the P region 11 is prevented from burning through the P-type doped polysilicon layer of the P region 11 to contact with the silicon substrate 1, thereby improving a cell yield.

In some other embodiments, a sum of a thickness of a first P-type doped polysilicon layer 22 and a thickness of a second P-type doped polysilicon layer 24 may be less than or equal to a sum of a thickness of a first N-type doped polysilicon layer 32 and a thickness of a second N-type doped polysilicon layer 34.

In some embodiments of the disclosure, a sum of a thickness of a first P-type doped polysilicon layer 22 and a thickness of a second P-type doped polysilicon layer 24 ranges from 80 nanometers to 210 nanometers.

In the embodiment, the sum of the thickness of the first P-type doped polysilicon layer 22 and the thickness of the second P-type doped polysilicon layer 24 is set to range from 80 nanometers to 210 nanometers. Thus, it can be ensured that the first P-type doped polysilicon layer 22 and the second P-type doped polysilicon layer 24 have an excellent capability to prevent electrode burnthrough, and can stop other impurities from entering the silicon substrate 1, thereby improving the passivation effect of the cell.

In some embodiments of the disclosure, a sum of a thickness of a first N-type doped polysilicon layer 32 and a thickness of a second N-type doped polysilicon layer 34 ranges from 60 nanometers to 200 nanometers.

In the embodiment, the sum of the thickness of the first N-type doped polysilicon layer 32 and the thickness of the second N-type doped polysilicon layer 34 is set to range from 60 nanometers to 200 nanometers. Thus, it can be ensured that the first N-type doped polysilicon layer 32 and the second N-type doped polysilicon layer 34 have an excellent capability to prevent electrode burnthrough, and can stop other impurities from entering the silicon substrate 1, thereby improving the passivation effect of the cell.

In some embodiments of the disclosure, a ratio of a thickness of a second N-type doped polysilicon layer 34 to a thickness of a first N-type doped polysilicon layer 32 ranges from 1 to 40.

In the embodiment, the ratio of the thickness of the second N-type doped polysilicon layer 34 to the thickness of the first N-type doped polysilicon layer 32 may be set according to actual requirements. For embodiment, the ratio of the thickness of the second N-type doped polysilicon layer 34 to the thickness of the first N-type doped polysilicon layer 32 may be 1, 2, 3, 5, 8, 10, 12, 15, 18, 20, 22, 25, 28, 30, 32, 36, or 40.

In some embodiments of the disclosure, a ratio of a thickness of a second N-type doped polysilicon layer 34 to a thickness of a first N-type doped polysilicon layer 32 ranges from 2 to 20.

In the embodiment, the ratio of the thickness of the second N-type doped polysilicon layer 34 to the thickness of the first N-type doped polysilicon layer 32 ranges from 2 to 20. Thus, it is ensured that a difference between the thickness of the second N-type doped polysilicon layer 34 and the thickness of the first N-type doped polysilicon layer 32 is within a more reasonable range, such that excellent ohmic contact with the second N-type doped polysilicon layer 34 and the excellent passivation effect of the first N-type doped polysilicon layer 32 can be well adapted, and it is convenient to prepare the second N-type doped polysilicon layer 34 and the first N-type doped polysilicon layer 32.

In some embodiments of the disclosure, a thickness of a first passivation layer 21 is greater than a thickness of a first barrier layer 23, and a thickness of a second passivation layer 31 is greater than a thickness of a second barrier layer 33.

In the embodiment, since the first barrier layer 23 thinner than the first passivation layer 21 is disposed between the second P-type doped polysilicon layer 24 and the first P-type doped polysilicon layer 22, the first barrier layer 23 has an effect of mutual stopping to some extent, such that a doping concentration difference is formed between two P-type doped polysilicon layers, and the passivation effect of the passivation contact structure of the solar cell can be further improved, thereby improving the cell efficiency. Moreover, the thickness of the first passivation layer 21 is greater than the thickness of the first barrier layer 23 can achieve an excellent passivation effect in a short period of time, and processing can be advantageous.

In the embodiment, since the second barrier layer 33 thinner than the second passivation layer 31 is disposed between the second N-type doped polysilicon layer 34 and the first N-type doped polysilicon layer 32, the second barrier layer 33 has an effect of mutual stopping to some extent, such that a doping concentration difference is formed between two N-type doped polysilicon layers, and the passivation effect of the passivation contact structure of the solar cell can be further improved, thereby improving the cell efficiency. Moreover, the thickness of the second passivation layer 31 is greater than the thickness of the second barrier layer 33 can achieve an excellent passivation effect in a short period of time, and processing can be advantageous.

In some embodiments of the disclosure, a total thickness of a first passivation layer 21, a first P-type doped polysilicon layer 22, a first barrier layer 23 and a second P-type doped polysilicon layer 24 is greater than a total thickness of a second passivation layer 31, a first N-type doped polysilicon layer 32, a second barrier layer 33 and a second N-type doped polysilicon layer 34.

In some embodiments of the disclosure, compared with the total thickness of the second passivation layer 31, the first N-type doped polysilicon layer 32, the second barrier layer 33 and the second N-type doped polysilicon layer 34, the passivation effect of the P regions 11 can be improved by increasing the total thickness of the first passivation layer 21, the first P-type doped polysilicon layer 22, the first barrier layer 23 and the second P-type doped polysilicon layer 24, thereby further improving the cell efficiency.

In some other embodiments, a total thickness of a first passivation layer 21, a first P-type doped polysilicon layer 22, a first barrier layer 23 and a second P-type doped polysilicon layer 24 may be less than or equal to a total thickness of a second passivation layer 31, a first N-type doped polysilicon layer 32, a second barrier layer 33 and a second N-type doped polysilicon layer 34.

In some embodiments of the disclosure, a thickness of a second P-type doped polysilicon layer 24 is greater than a thickness of a second N-type doped polysilicon layer 34, such that it is convenient to control a total thickness of a first passivation contact structure 2 of P regions 11 to be greater than a total thickness of a second passivation contact structure 3 of N regions 12. In some other embodiments, a second P-type doped polysilicon layer 24 may have a thickness less than a thickness of a second N-type doped polysilicon layer 34.

In some embodiments of the disclosure, a thickness of a second N-type doped polysilicon layer 34 is greater than a thickness of a first P-type doped polysilicon layer 22, such that it is convenient to further control a total thickness of a first passivation contact structure 2 of P regions 11 to be greater than a total thickness of a second passivation contact structure 3 of N regions 12.

In some embodiments of the disclosure, a thickness of a first P-type doped polysilicon layer 22 is greater than a thickness of a first N-type doped polysilicon layer 32, such that it is convenient to further control a total thickness of a first passivation contact structure 2 of P regions 11 to be greater than a total thickness of a second passivation contact structure 3 of N regions 12.

In some embodiments of the disclosure, a sum of a thicknesses of a first passivation layer 21 and a thickness of a first barrier layer 23 ranges from 1.5 nanometers to 2.8 nanometers.

In the embodiment, the sum of the thickness of the first passivation layer 21 and the thickness of the first barrier layer 23 is set to range from 1.5 nanometers to 2.8 nanometers. Thus, the passivation effect of the P regions 11 can be improved, and the cell efficiency can be improved. Moreover, the P regions can have an excellent contact effect, thereby improving a production yield of the back-contact solar cell.

For example, the sum of the thickness of the first passivation layer 21 and the thickness of the first barrier layer 23 may be 1.5 nanometers, 1.6 nanometers, 1.7 nanometers, 1.8 nanometers, 2.0 nanometers, 2.1 nanometers, 2.2 nanometers, 2.3 nanometers, 2.4 nanometers, 2.5 nanometers, 2.6 nanometers, 2.7 nanometers, or 2.8 nanometers.

In some embodiments of the disclosure, a first barrier layer 23 is greater than 0.8 nanometer.

In the embodiment, a thickness of the first barrier layer 23 is greater than 0.8 nanometer. Thus, the first barrier layer 23 can achieve an excellent effect of impurity stopping of the first barrier layer 23 can be achieved. For example, the thickness of the first barrier layer 23 may be 0.8 nanometer, 0.9 nanometer, 1.0 nanometer, 1.2 nanometers, 1.5 nanometers, or 2.0 nanometers.

In some embodiments of the disclosure, a sum of a thickness of a first passivation layer 21 and a thickness of a first barrier layer 23 is greater than a sum of a thickness of a second passivation layer 31 and a second barrier layer 33.

In the embodiment, the sum of the thickness of the first passivation layer 21 and the thickness of the first barrier layer 23 is set to be greater than the sum of the thickness of the second passivation layer 31 and the thickness of the second barrier layer 33. That is, by increasing the sum of the thickness of the first passivation layer 21 and the thickness of the first barrier layer 23, the passivation effect of the P regions 11 can be improved, thereby improving the cell efficiency.

In some other embodiments of the disclosure, a sum of a thickness of a first passivation layer 21 and a thickness of a first barrier layer 23 may be less than or equal to a sum of a thickness of a second passivation layer 31 and a thickness of a second barrier layer 33.

In some embodiments of the disclosure, a first passivation layer 21 includes one or a combination of silicon oxide, silicon oxynitride and silicon nitride each containing boron or gallium; and a second passivation layer 31 includes one or a combination of silicon oxide, silicon oxynitride and silicon nitride each containing phosphorus.

In the embodiment, the first passivation layer 21 is made of the material described above. Thus, the excellent effects of impurity stopping and passivation of the first passivation layer 21 can be achieved. The second passivation layer 31 is made of the material described above. Thus, the excellent effects of impurity stopping and passivation of the first passivation layer 21 can also be achieved.

In some embodiments of the disclosure, a first barrier layer 23 includes one or a combination of silicon oxide, silicon oxynitride, silicon nitride and silicon carbide each containing boron or gallium, and a second barrier layer 33 includes one or a combination of silicon oxide, silicon oxynitride, silicon nitride and silicon carbide each containing phosphorus.

In the embodiment, the first barrier layer 23 is any one of silicon oxide, silicon oxynitride, silicon nitride or silicon carbide each containing boron or gallium. In some other embodiments, a first barrier layer 23 is any combination of silicon oxide, silicon oxynitride, silicon nitride and silicon carbide each containing boron or gallium. In some embodiments. The second barrier layer 33 is any one of silicon oxide, silicon oxynitride, silicon nitride or silicon carbide each containing phosphorus. In some other embodiments, a second barrier layer 33 is any combination of silicon oxide, silicon oxynitride, silicon nitride or silicon carbide each containing phosphorus.

In some embodiments of the disclosure, a first passivation layer 21 and a second passivation layer 31 are each provided with holes (not shown). The first P-type doped polysilicon layer 22 makes contact with a silicon substrate 1 by the holes on the first passivation layer 21, and the first N-type doped polysilicon layer 32 makes contact with the silicon substrate 1 by the holes on the second passivation layer 31.

In the embodiment, the holes of the first passivation layer 21 vertically penetrate the first passivation layer 21, and the hole of the second passivation layer 31 vertically penetrate the second passivation layer 31. An inward diffusion layer is further disposed inside the silicon substrate 1. The first P-type doped polysilicon layer 22 makes contact with the inward diffusion layer inside the silicon substrate 1 by the holes on the first passivation layer 21, and the first N-type doped polysilicon layer 32 makes contact with the inward diffusion layer inside the silicon substrate 1 by the holes on the second passivation layer 31. The first P-type doped polysilicon layer 22 makes contact with the silicon substrate 1 by the holes on the first passivation layer 21, and the first N-type doped polysilicon layer 32 makes contact with the silicon substrate 1 by the holes on the second passivation layer 31. Thus, current loss can be reduced advantageously, and the conversion efficiency of the cell can be improved.

In some embodiments, holes of a first passivation layer 21 and a second passivation layer 31 are prepared by means of chemical etching, dry etching or thermal diffusion shock, and are prepared according to actual use requirements, which are not specifically limited herein. The first passivation layer 21 and the second passivation layer 31 exhibit porous structures when the first passivation layer 21 and the second passivation layer 31 are viewed from a top-down perspective, and the first passivation layer 21 and the second passivation layer 31 exhibit multi-channel structures when the first passivation layer 21 and the second passivation layer 31 are viewed from a cross-sectional perspective.

In some embodiments of the disclosure, a first passivation layer 21 and a first barrier layer 23 are each provided with hole. A hole density of the first passivation layer 21 is less than a hole density of the first barrier layer 23.

In the embodiment, the hole density of the first passivation layer 21 is less than the hole density of the first barrier layer 23. It can be understood that the number of the holes of the first passivation layer 21 is less than the number of the holes of the first barrier layer 23 per unit area. Since the hole density of the first passivation layer 21 is less than the hole density of the first barrier layer 23, conductivity of the first passivation layer 21 and the first barrier layer 23 can be enhanced sequentially. Moreover, the effect of impurity adsorption of the silicon substrate 1 can be improved advantageously, and the cell efficiency can be improved advantageously.

In some embodiments of the disclosure, a first passivation layer 21 and a first barrier layer 23 are each provided with holes. An average hole diameter of the holes of the first passivation layer 21 is less than an average hole diameter of the holes of the first barrier layer 23.

In some embodiments, hole diameters of each hole of a first passivation layer 21 are equal to each other. In some other embodiments, hole diameters of at least some of holes of a first passivation layer 21 are unequal. Similarly, in some embodiments, hole diameters of each hole of a first barrier layer 23 are equal to each other. In some other embodiments, hole diameters of at least some of holes of a first barrier layer 23 are unequal. An average hole diameter of the holes of the first passivation layer 21 can be understood as an average hole diameter of all the holes of the first passivation layer 21; and an average hole diameter of the holes of the first barrier layer 23 can be understood as an average hole diameter of all the holes of the first barrier layer 23. By setting the average hole diameter of the holes of the first passivation layer 21 to be less than the average hole diameter of the holes of the first barrier layer 23, the passivation effect of the first passivation layer 21 on the back surface of the silicon substrate 1 can be improved advantageously, and the cell efficiency can be improved advantageously.

In some embodiments of the disclosure, a second passivation layer 31 and a second barrier layer 33 are each provided with holes. A hole density of the second passivation layer 31 is less than a hole density of the second barrier layer 33.

In the embodiment, the hole density of the second passivation layer 31 is less than the hole density of the second barrier layer 33. It can be understood that the number of the holes of the second passivation layer 31 is less than the number of the holes of the second barrier layer 33 per unit area. Since the hole density of the second passivation layer 31 is less than the hole density of the second barrier layer 33, conductivity of the second passivation layer 31 and the second barrier layer 33 can be enhanced sequentially. Moreover, the effect of impurity adsorption of the silicon substrate 1 can be improved advantageously, and the cell efficiency can be improved advantageously.

In some embodiments of the disclosure, a second passivation layer 31 and a second barrier layer 33 are each provided with holes. An average hole diameter of the holes of the second passivation layer 31 is less than an average hole diameter of the holes of the second barrier layer 33.

In some embodiments, hole diameters of each hole of a second passivation layer 31 are equal to each other. In some other embodiments, hole diameters of at least some of holes of a second passivation layer 31 are unequal. Similarly, in some embodiments, hole diameters of each hole of a second barrier layer 33 are equal to each other. In some other embodiments, hole diameters of at least some of holes of a second barrier layer 33 are unequal. An average hole diameter of the holes of the second passivation layer 31 can be understood as the average hole diameter of all the holes of the second passivation layer 31, and an average hole diameter of the holes of the second barrier layer 33 can be understood as the average hole diameter of all the holes of the second barrier layer 33. By setting the average hole diameter of the holes of the second passivation layer 31 to be less than the average hole diameter of the holes of the second barrier layer 33, the passivation effect of the second passivation layer 31 on the back surface of the silicon substrate 1 can be improved advantageously, and the cell efficiency can be improved advantageously.

In some embodiments of the disclosure, a doping concentration a P-type dopant in a first passivation layer 21 is less than a doping concentration of a P-type dopant in a first barrier layer 23. Thus, a capability of the first barrier layer 23 to stop impurities from entering the silicon substrate 1 can be improved advantageously. In some other embodiments, a doping concentration of a first passivation layer 21 is greater than or equal to a doping concentration of a first barrier layer 23.

In some other embodiments, a back surface passivation layer, such as a silicon nitride layer, is further stacked on a surface of a second N-type doped polysilicon layer 34 away from a silicon substrate 1 to further improve the passivation effect of the cell.

### Embodiment 2

With reference to Fig. 2, on the basis of embodiment 1, a first passivation contact structure 2 further includes:
a third barrier layer 25 disposed on one surface of the second P-type doped polysilicon layer 24 away from the silicon substrate 1.

In the embodiment, first electrodes 4 pass through a third barrier layer 25 to make contact with a second P-type doped polysilicon layer 24. By providing the third barrier layer 25 on the surface of the second P-type doped polysilicon layer 24 away from the silicon substrate 1, impurities can be stopped form diffusing inwards into the silicon substrate 1 by the third barrier layer 25. Thus, the impurities can be further stopped from diffusing inwards into the silicon substrate 1. Moreover, dopant atoms of the second P-type doped polysilicon layer 24 can be prevented from flowing outwards by the third barrier layer 25, thereby further improving the passivation effect of the cell.

In some embodiments of the disclosure, a thickness of a third barrier layer 25 is less than a thickness of a first passivation layer 21.

In the embodiment, the thickness of the third barrier layer 25 is less than the thickness of the first passivation layer 21, making the first passivation layer 21 thicker than the first passivation layer 21, such that the passivation effect of the first passivation layer 21 can be improved.

In some embodiments of the disclosure, a first passivation contact structure further includes:
a third P-type doped polysilicon layer 26 disposed on one surface of the third barrier layer 25 away from the silicon substrate 1.

In the embodiment, by adding the third P-type doped polysilicon layer 26, the passivation effect of the P regions 11 can be further enhanced by the third P-type doped polysilicon layer 26. The first electrodes 4 pass through the third P-type doped polysilicon layer 26 and the third barrier layer 25 to make contact with the second P-type doped polysilicon layer 24. In some embodiments, a first electrode 4 makes direct contact with a third P-type doped polysilicon layer 26.

In some embodiments of the disclosure, a doping concentration of a P-type dopant in a second P-type doped polysilicon layer 24 is greater than a doping concentration of a P-type dopant in a third P-type doped polysilicon layer 26.

In the embodiment, since the doping concentration of the P-type dopant in the second P-type doped polysilicon layer 24 is greater than the doping concentration of the third P-type doped polysilicon layer 26, a light transmittance of the P region 11 can be improved. Thus, the passivation effect can be enhanced, and an excellent utilization rate of sunlight can be ensured.

In some embodiments of the disclosure, a second passivation contact structure 3 further includes:
a fourth barrier layer 35 disposed on one surface of the second N-type doped polysilicon layer 34 away from the silicon substrate 1.

In the embodiment, second electrodes 5 pass through a fourth barrier layer 35 to make contact with a second N-type doped polysilicon layer 34. By providing the fourth barrier layer 35 on the surface of the second N-type doped polysilicon layer 34 away from the silicon substrate 1, impurities can be stopped from diffusing inwards into the silicon substrate 1 by the fourth barrier layer 35. Thus, the impurities can be further stopped from diffusing inwards into the silicon substrate 1. Moreover, doped atoms of the N-type doped polysilicon layer can be stopped from flowing outwards by the fourth barrier layer 35, thereby further improving the passivation effect of the cell.

In some embodiments of the disclosure, a thickness of a fourth barrier layer 35 is less than a thickness of a second passivation layer 31.

In the embodiment, the fourth barrier layer 35 is less than the thickness of the first passivation layer 21, making the fourth barrier layer 35 is thicker than the second passivation layer 31, such that the passivation effect of the first passivation layer 21 can be improved.

In some embodiments of the disclosure, a second passivation contact structure further includes:
a third N-type doped polysilicon layer 36 disposed on one surface of the fourth barrier layer 35 away from the silicon substrate 1.

In the embodiment, by adding the third N-type doped polysilicon layer 36, the passivation effect of the N regions 12 of the cell can be further enhanced by the third N-type doped polysilicon layer 36.

In the embodiment, the second electrodes 5 pass through the third N-type doped polysilicon layer 36 and the fourth barrier layer 35 to make contact with the second N-type doped polysilicon layer 34. In some embodiments, second electrodes 5 make direct contact with a third N-type doped polysilicon layer 36.

In some embodiments of the disclosure, a doping concentration of an N-type dopant in a third N-type doped polysilicon layer 36 is greater than a doping concentration of an N-type dopant in a second N-type doped polysilicon layer 34.

In some other embodiments, a stacked structure including a barrier layer alternately disposed on a P-type doped polysilicon layer is further stacked on a surface of a third P-type doped polysilicon layer 26 away from a silicon substrate 1, and a stacked structure including a barrier layer alternately disposed on an N-type doped polysilicon layer is further stacked on a surface of the third N-type doped polysilicon layer 36 away from the silicon substrate 1, so as to further improve the passivation effect of the cell.

Moreover, in some other embodiments, at least one back surface passivation layer, such as silicon nitride layer, is further stacked on surface of a third P-type doped polysilicon layer 26 and a third N-type doped polysilicon layer 36 away from a silicon substrate 1, so as to further improve the passivation effect of the cell.

### Embodiment 3

A cell assembly is further provided in an embodiment of the disclosure. The cell assembly includes the back-contact solar cell of embodiment 1 or embodiment 2 described above. It should be noted that the cell assembly has the same or similar beneficial effects as the back-contact solar cell described above, and relevant contents between the cell assembly and the back-contact solar cell can refer to each other, which are not be repeated herein to avoid repetition.

### Embodiment 4

A photovoltaic system is further provided in an embodiment of the disclosure. The photovoltaic system includes the cell assembly of embodiment 3 described above. It should be noted that the photovoltaic system has the same or similar beneficial effects as the back-contact solar cell, and relevant contents between the photovoltaic system and the back-contact solar cell can refer to each other, which are not repeated herein to avoid repetition.

The first passivation contact structure 2 of the P regions 11 of the back-contact solar cell according to the disclosure includes the first passivation layer 21, the first P-type doped polysilicon layer 22, the first barrier layer 23 and the second P-type doped polysilicon layer 24 sequentially stacked on the surface of the silicon substrate 1, and the second passivation contact structure 3 of the N regions 12 includes the second passivation layer 31, the first N-type doped polysilicon layer 32, the second barrier layer 33 and the second N-type doped polysilicon layer 34 sequentially stacked on the surface of the silicon substrate 1. The first passivation contact structure 2 stops impurities from diffusing inwards into the silicon substrate 1 together by the first passivation layer 21 and the first barrier layer 23, and the second passivation contact structure 3 stops impurities from diffusing inwards into the silicon substrate 1 together by the second passivation layer 31 and the second barrier layer 33, such that inward diffusion of the impurities into the silicon substrate 1 can be obviously reduced, excessive impurities can be prevented from diffusing into the silicon substrate 1, and a passivation effect of the back-contact solar cell can be obviously improved, thereby improving cell efficiency.

Moreover, the doping concentration of the P-type dopant in the first P-type doped polysilicon layer 22 of the back-contact solar cell of the disclosure is greater than the doping concentration of the P-type dopant in the second P-type doped polysilicon layer 24, and the doping concentration of the N-type dopant in the first N-type doped polysilicon layer 32 is less than the doping concentration of the N-type dopant in the second N-type doped polysilicon layer 34. By reducing the doping concentration of the P-type dopant in the second P-type doped polysilicon layer 24 of the P region 11, a light transmittance of the second P-type doped polysilicon layer 24 can be increased, thereby improving a utilization rate of the back-contact solar cell to sunlight, and further improving the cell efficiency.

What are described above are merely preferred embodiments of the disclosure, and are not intended to limit the disclosure. Any modifications, equivalent substitutions, improvements, etc. made within the spirit and principles of the disclosure should fall within the scope of protection of the disclosure.

## Claims

1. A back-contact solar cell, comprising:
a silicon substrate, wherein a back surface of the silicon substrate comprises P regions and N regions;
a first passivation contact structure disposed in the P regions, wherein the first passivation contact structure comprises a first passivation layer, a first P-type doped polysilicon layer, a first barrier layer and a second P-type doped polysilicon layer sequentially stacked on the back surface of the silicon substrate; and
a second passivation contact structure disposed in the N regions, wherein the second passivation contact structure comprises a second passivation layer, a first N-type doped polysilicon layer, a second barrier layer and a second N-type doped polysilicon layer sequentially stacked on the back surface of the silicon substrate;
wherein a doping concentration of a P-type dopant in the first P-type doped polysilicon layer is greater than a doping concentration of a P-type dopant in the second P-type doped polysilicon layer, and a doping concentration of an N-type dopant in the first N-type doped polysilicon layer is less than a doping concentration of an N-type dopant in the second N-type doped polysilicon layer.

2. The back-contact solar cell according to claim 1, wherein a ratio of the doping concentration of the P-type dopant in the first P-type doped polysilicon layer to the doping concentration of the P-type dopant in the second P-type doped polysilicon layer ranges from 1 to 2, and is unequal to 1.

3. The back-contact solar cell according to claim 1, wherein a ratio of the doping concentration of the P-type dopant in the first P-type doped polysilicon layer to the doping concentration of the P-type dopant in the second P-type doped polysilicon layer ranges from 1.01 to 1.50.

4. The back-contact solar cell according to claim 1, wherein the doping concentration of the P-type dopant in the first P-type doped polysilicon layer and the doping concentration of the P-type dopant in the second P-type doped polysilicon layer both range from 3×10¹⁹ atoms/cm³ to 15×10¹⁹ atoms/cm³.

5. The back-contact solar cell according to claim 1, wherein a ratio of the doping concentration of the N-type dopant in the first N-type doped polysilicon layer to the doping concentration of the N-type dopant in the second N-type doped polysilicon layer ranges from 0.5 to 1.

6. The back-contact solar cell according to claim 1, wherein the doping concentration of the N-type dopant in the first N-type doped polysilicon layer and the doping concentration of the N-type dopant in the second N-type doped polysilicon layer both range from 0.5×10²⁰ atoms/cm³ to 1.2×10²¹ atoms/cm³.

7. The back-contact solar cell according to claim 1, further comprising:
first electrodes each disposed in one of the P regions, contacting the second P-type doped polysilicon layer; and
second electrodes each disposed in one of the N regions, contacting the second N-type doped polysilicon layer.

8. The back-contact solar cell according to claim 7, wherein a thickness of the first P-type doped polysilicon layer is less than a thickness of the second P-type doped polysilicon layer.

9. The back-contact solar cell according to claim 7, wherein a thickness of the first N-type doped polysilicon layer is less than a thickness of the second N-type doped polysilicon layer.

10. The back-contact solar cell according to claim 8, wherein a ratio of the thickness of the second P-type doped polysilicon layer to the thickness of the first P-type doped polysilicon layer ranges from 1 to 30.

11. The back-contact solar cell according to claim 8, wherein a ratio of the thickness of the second P-type doped polysilicon layer to the thickness of the first P-type doped polysilicon layer ranges from 1.5 to 15.

12. The back-contact solar cell according to claim 1, wherein a sum of a thickness of the first P-type doped polysilicon layer and a thickness of the second P-type doped polysilicon layer ranges from 80 nanometers to 210 nanometers.

13. The back-contact solar cell according to claim 1, wherein a sum of a thickness of the first N-type doped polysilicon layer and a thickness of the second N-type doped polysilicon layer ranges from 60 nanometers to 200 nanometers.

14. The back-contact solar cell according to claim 1, wherein a sum of a thickness of the first P-type doped polysilicon layer and a thickness of the second P-type doped polysilicon layer is greater than a sum of a thickness of the first N-type doped polysilicon layer and a thickness of the second N-type doped polysilicon layer.

15. The back-contact solar cell according to claim 1, wherein a sum of a thicknesses of the first passivation layer and a thickness of the first barrier layer ranges from 1.5 nanometers to 2.8 nanometers.

16. The back-contact solar cell according to claim 1, wherein a sum of a thickness of the first passivation layer and a thickness of the first barrier layer is greater than a sum of a thickness of the second passivation layer and a thickness of the second barrier layer.

17. The back-contact solar cell according to claim 1, wherein a thickness of the first barrier layer is greater than 0.8 nanometer.

18. The back-contact solar cell according to claim 9, wherein a ratio of the thickness of the second N-type doped polysilicon layer to the thickness of the first N-type doped polysilicon layer ranges from 1 to 40.

19. The back-contact solar cell according to claim 9, wherein a ratio of the thickness of the second N-type doped polysilicon layer to the thickness of the first N-type doped polysilicon layer ranges from 2 to 20.

20. The back-contact solar cell according to claim 7, wherein the first electrode enters the second P-type doped polysilicon layer and does not enter the first barrier layer, and the second electrode enters the second N-type doped polysilicon layer and does not enter the second barrier layer.

21. The back-contact solar cell according to claim 7, wherein a depth that the first electrode enters the second P-type doped polysilicon layer is greater than a depth that the second electrode enters the second N-type doped polysilicon layer.

22. The back-contact solar cell according to claim 1, wherein a total thickness of the first passivation layer, the first P-type doped polysilicon layer, the first barrier layer and the second P-type doped polysilicon layer is greater than a total thickness of the second passivation layer, the first N-type doped polysilicon layer, the second barrier layer and the second N-type doped polysilicon layer.

23. The back-contact solar cell according to claim 1, wherein a thickness of the second P-type doped polysilicon layer is greater than a thickness of the second N-type doped polysilicon layer.

24. The back-contact solar cell according to claim 1, wherein a thickness of the second N-type doped polysilicon layer is greater than a thickness of the first P-type doped polysilicon layer.

25. The back-contact solar cell according to claim 1, wherein a thickness of the first P-type doped polysilicon layer is greater than a thickness of the first N-type doped polysilicon layer.

26. The back-contact solar cell according to claim 1, wherein a thickness of the first passivation layer is greater than a thickness of the first barrier layer; and a thickness of the second passivation layer is greater than a thickness of the second barrier layer.

27. The back-contact solar cell according to claim 1, wherein the first passivation layer comprises one or a combination of silicon oxide, silicon oxynitride and silicon nitride containing boron or gallium; and the second passivation layer comprises one or a combination of silicon oxide, silicon oxynitride and silicon nitride containing phosphorus.

28. The back-contact solar cell according to claim 1, wherein the first barrier layer comprises one or a combination of silicon oxide, silicon oxynitride, silicon nitride and silicon carbide, each of which contains boron or gallium; and the second barrier layer comprises one or a combination of silicon oxide, silicon oxynitride, silicon nitride and silicon carbide, each of which contains phosphorus.

29. The back-contact solar cell according to claim 1, wherein the first passivation contact structure further comprises:
a third barrier layer disposed on a surface of the second P-type doped polysilicon layer away from the silicon substrate.

30. The back-contact solar cell according to claim 29, wherein a thickness of the third barrier layer is less than a thickness of the first passivation layer.

31. The back-contact solar cell according to claim 29, wherein the first passivation contact structure further comprises:
a third P-type doped polysilicon layer disposed on a surface of the third barrier layer away from the silicon substrate.

32. The back-contact solar cell according to claim 31, wherein a doping concentration of a P-type dopant in the second P-type doped polysilicon layer is greater than a doping concentration of a P-type dopant in the third P-type doped polysilicon layer.

33. The back-contact solar cell according to claim 1, wherein the second passivation contact structure further comprises:
a fourth barrier layer disposed on a surface of the second N-type doped polysilicon layer away from the silicon substrate.

34. The back-contact solar cell according to claim 33, wherein a thickness of the fourth barrier layer is less than a thickness of the second passivation layer.

35. The back-contact solar cell according to claim 33, wherein the second passivation contact structure further comprises:
a third N-type doped polysilicon layer disposed on a surface of the fourth barrier layer away from the silicon substrate.

36. The back-contact solar cell according to claim 35, wherein a doping concentration of an N-type dopant in the third N-type doped polysilicon layer is greater than a doping concentration of a N-type dopant in the second N-type doped polysilicon layer.

37. A cell assembly, comprising: the back-contact solar cell according to any one of claims 1-36.

38. A photovoltaic system, comprising: the cell assembly according to claim 37.
